(19)

Europäisches Patentamt
European Patent Office
Office européen des brevets

(11) **EP 2 896 995 A1**

(12) **EUROPEAN PATENT APPLICATION**

(43) Date of publication:
**22.07.2015 Bulletin 2015/30**

(51) Int Cl.:
*G03F 7/20* (2006.01)          *H01S 3/09* (2006.01)
*H05H 7/04* (2006.01)

(21) Application number: **14151497.6**

(22) Date of filing: **16.01.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ASML Netherlands B.V.**
**5500 AH Veldhoven (NL)**

(72) Inventors:
• **Nikipelov, Andrey, Alexandrovich**
  **5500 AH Veldhoven (NL)**
• **De Vries, Gosse, Charles**
  **5500 AH Veldhoven (NL)**
• **Engelen, Wouter, Joep**
  **5500 AH Veldhoven (NL)**

• **Frijns, Olav, Waldemar, Vladimir**
  **5500 AH Veldhoven (NL)**
• **Grimminck, Leonardus, Adrianus, Gerardus**
  **5500 AH Veldhoven (NL)**
• **Loopstra, Erik, Roelof**
  **5500 AH Veldhoven (NL)**

(74) Representative: **Siem, Max Yoe Shé**
**ASML Netherlands B.V.**
**Corporate Intellectual Property**
**P.O. Box 324**
**5500 AH Veldhoven (NL)**

Remarks:
Claims 16 to 25 are deemed to be abandoned due to non-payment of the claims fees (Rule 45(3) EPC).

(54) **A radiation source**

(57) An undulator (30) for a free electron laser. The undulator comprises at least one undulator module (31,32,33) operable to produce a periodic magnetic field and arranged so as to guide an electron beam (E) along a periodic path such that electrons within the electron beam interact with radiation (P1,P2,P3) in the undulator to stimulate emission of coherent radiation to provide a radiation beam. The undulator further comprises a steering unit (38a,38b) arranged to alter a trajectory of the electron beam within the at least one undulator module, and a control unit (39) arranged to control to the steering unit.

FIG. 4

EP 2 896 995 A1

**Description**

FIELD

The present invention relates to an undulator for directing electron beams in a free electron laser, and has particular, but not exclusive application for generating radiation for a lithographic system.

BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 5-20 nm, may be used to form smaller features on a substrate than a conventional lithographic apparatus (which may for example use electromagnetic radiation with a wavelength of 193 nm).

It is desirable to produce EUV radiation sources with increased power to increase throughput of EUV lithography.

SUMMARY

According to a first aspect of the invention there is a provided an undulator for a free electron laser, comprising: at least one undulator module operable to produce a periodic magnetic field and arranged so as to guide an electron beam along a periodic path such that electrons within the electron beam interact with radiation in the undulator to stimulate emission of coherent radiation to provide a radiation beam; a steering unit arranged to alter a trajectory of the electron beam within the at least one undulator module; and a control unit arranged to control to the steering unit.

In this way, the control unit can steer the electron beam, and therefore the radiation beam, within the at least one module of the undulator itself, thereby adjusting the radiation beam at the position in the path of the radiation beam where such adjustments have the greatest effect.

The steering unit may be positioned within the undulator at a location that is nearer to an exit of the undulator than an entrance of the undulator in relation to the direction of propagation of the electron beam.

The steering unit may be positioned between a final and a penultimate module of the undulator with respect to direction of propagation of the electron beam. That is, where a plurality of modules is provided, the electron beam moves between each module in turn. The final module that the electron beam passes through is the final module. The module through which the electron beam passes before entering the final module is the penultimate module.

The undulator may further comprise a sensor arrangement for providing a signal indicative of a trajectory of the electron beam to the control unit.

The sensor arrangement may comprise a first sensor positioned after a first one of the plurality of undulator modules and a second sensor positioned after a second one of the plurality of undulator modules.

The first sensor may be positioned after a penultimate module and the second sensor may be positioned after a final module.

The control unit may be arranged to determine a deviation of the trajectory of the electron beam from an ideal trajectory.

The control unit may be arranged to control the steering unit to reduce a difference between the trajectory of the electron beam and the ideal trajectory, or to substantially align the electron beam with a trajectory parallel to the ideal trajectory.

The control unit may be arranged to receive an indication of an intensity distribution within the radiation beam at a predetermined location. For example, the predetermined location may be a position at which optics for processing the radiation beam further are located. For example, the predetermined location may be at a position of a beam expander that is part of a lithographic system.

The undulator may be arranged to determine a difference between the intensity distribution within the radiation beam at the predetermined location and an ideal intensity distribution within the radiation beam at the predetermined location; and to control the steering unit to reduce the difference between the intensity distribution within the radiation beam at the predetermined location and an ideal intensity distribution within the radiation beam at the predetermined location.

The control unit may be arranged to control the steering unit to periodically vary the trajectory of the electron beam by a predetermined amount.

The control unit may be arranged to control steering unit to sequentially direct the electron beam at a plurality of discreet angles with respect to a longitudinal axis of the undulator.

The plurality of discreet angles may be selected so as to provide a plurality of spatially separate radiation beams.

The control unit may be arranged to control the steering unit to sweep the electron beam through a predetermined angular range with respect to a longitudinal axis of the undulator.

The control unit may be arranged to control the steering unit so as to provide a plurality of spatially overlapping radiation beams. In this way, averaged over time, a the plurality of overlapping beams may provide a substantially flat-top beam profile.

The control unit may be arranged to control the steering unit to sweep the electron beam through the predetermined angular range with a substantially constant angular speed.

The control unit may be arranged to control the steering unit to vary the trajectory up to an angle of 1000 $\mu$rad in a direction perpendicular to a longitudinal axis of the undulator. For example, the control unit may be arranged to control the steering unit to vary the trajectory up to angle of 1000 $\mu$rad within a planar undulator module when sweeping the electron beam in a plane perpendicular to magnetic field lines within the planar undulator module, and up to 100 $\mu$rad within a helical undulator module.

The steering unit may be a first steering unit and the undulator may further comprise a second steering unit placed after a final module of the undulator, the control unit being arranged to control the second steering unit to reduce a difference between a propagation trajectory of the electron beam before variation of the electron beam by the first steering unit and a propagation trajectory after variation of the electron beam by the first steering unit. For example, the second steering unit may be controlled by the control unit to restore the trajectory of the electron beam to a trajectory of the electron beam before the electron beam interacted with the first steering unit. In this way, the electron beam can be made to follow a desired path (that may be different to a desired path of the radiation beam), such as a path to a beam dump.

The undulator may further comprise a plurality of steering units controlled by the control unit to alter a direction of the electron beam.

According to a second aspect, there is provided a free electron laser arranged to produce at least one radiation beam, the electron laser comprising an undulator according to the first aspect.

According to a third aspect, there is provided a lithographic system comprising: a free electron laser arranged to produce at least one radiation beam according to the second aspect; and at least one lithographic apparatus, each of the at least one lithographic apparatus being arranged to receive at least one of the at least one radiation beams.

The lithographic system may further comprise optics arranged to alter the size and/or shape of the cross section of the at least one radiation beams received from the free electron laser. For example, the lithographic system may comprise beam expander optics.

The lithographic system may further comprise an intensity distribution sensor arranged to provide signals indicative of an intensity distribution within the at least one radiation beam to the control unit of the undulator. The intensity distribution sensor may be positioned, for example, in the vicinity of the beam expander optics.

The at least one lithographic apparatus may comprise one or more mask inspection apparatus.

The at least one radiation beam may comprise EUV radiation.

According to a fourth aspect, there is provided a computer implemented method for varying a direction of an electron beam within an undulator operable to produce a periodic magnetic field and arranged so as to guide the electron beam along a periodic path such that electrons within the electron beam interact with radiation in the undulator to stimulate emission of coherent radiation to provide a radiation beam, the method comprising: receiving a signal indicative of a trajectory of the electron beam and/or receiving a signal indicative of an intensity distribution within the radiation beam at a predetermined location; determining a deviation of the trajectory of the electron beam from an ideal trajectory and/or determining a difference between the intensity distribution within the radiation beam at the predetermined location and an ideal intensity distribution within the radiation beam at the predetermined location; and controlling a steering unit within the undulator to steer the electron beam within a module of the undulator so as to reduce the determined deviation and/or so as to reduce the determined difference.

Various aspects and features of the invention set out above or below may be combined with various other aspects and features of the invention as will be readily apparent to the skilled person.

BRIEF DESCRIPTION OF THE DRAWINGS

Embodiments of the invention will now be described, by way of example only, with reference to the accompanying schematic drawings, in which:

- Figure 1 is a schematic illustration of a lithographic system comprising a free electron laser according to an embodiment of the invention and eight lithographic apparatuses;

- Figure 2 is a schematic illustration of a lithographic apparatus that forms part of the lithographic system of Figure 1;
- Figure 3 is a schematic illustration of a free electron laser according to an embodiment of the invention;
- Figure 4 is a schematic illustration of an undulator according to an embodiment of the invention;
- Figure 5 is a schematic illustration of an undulator according to an alternative embodiment of the invention;
- Figure 6 is a schematic illustration of an undulator according to a further embodiment of the invention; and
- Figure 7 is a schematic illustration of an undulator according to a further embodiment of the invention.

DETAILED DESCRIPTION

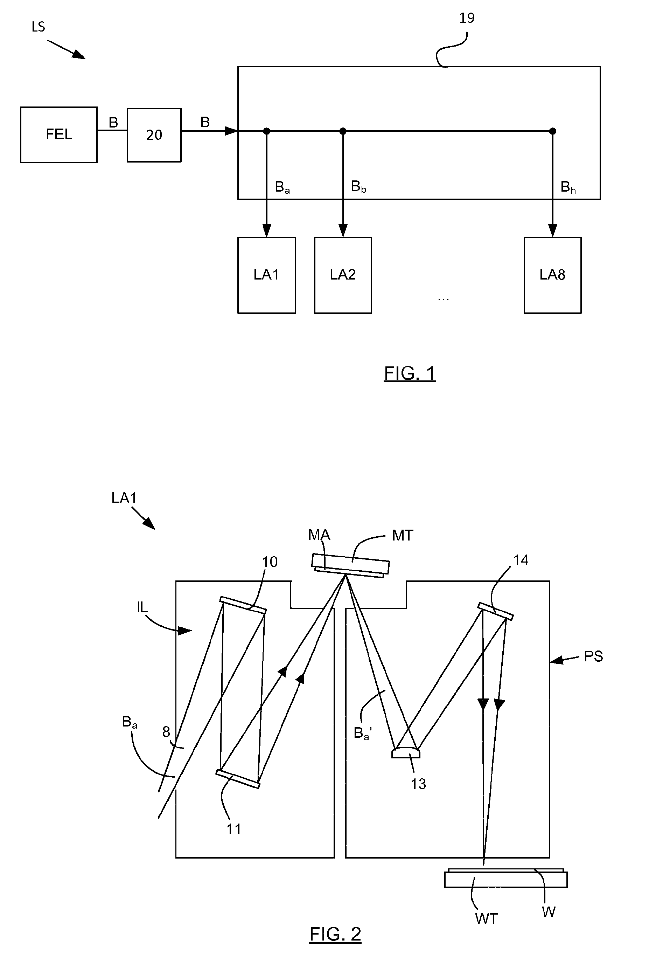

Figure 1 shows a lithographic system LS according to one embodiment of the invention. The lithographic system LS comprises a radiation source SO, a beam splitting apparatus 19 and eight lithographic apparatuses LA1-LA8. The radiation source SO is configured to generate an extreme ultraviolet (EUV) radiation beam B (which may be referred to as a main beam). The main radiation beam B is split into a plurality of radiation beams $B_a$-$B_h$ (which may be referred to as branch beams), each of which is directed to a different one of the lithographic apparatuses LA1-LA8, by the beam splitting apparatus 19. The branch radiation beams $B_a$-$B_h$ may be split off from the main radiation beam in series, with each branch radiation beam being split off from the main radiation beam downstream from the preceding branch radiation beam. Where this is the case the branch radiation beams may for example propagate substantially parallel to each other.

The lithographic system LS further comprises beam expanding optics 20. The beam expanding optics 20 are arranged to increase the cross sectional area of the radiation beam B. Advantageously, this decreases the heat load on mirrors downstream of the beam expanding optics 20. This may allow the mirrors downstream of the beam expanding optics to be of a lower specification, with less cooling, and therefore less expensive. Additionally or alternatively, it may allow the downstream mirrors to be nearer to normal incidence. The beam splitting apparatus 19 may comprise a plurality of static extraction mirrors (not shown) arranged in the path of the beam B which direct radiation from the main beam B along the plurality of branch radiation beams $B_a$-$B_h$. Increasing the size of the main beam B reduces the accuracy with which the mirrors must be located in the beam B path. Therefore, this allows for more accurate splitting of the output beam B by the splitting apparatus 19. For example, the beam expanding optics 20 may be operable to expand the main beam B from approximately 100 $\mu$m to more than 10 cm before the main beam B is split by the beam splitting apparatus 19.

The radiation source SO, beam splitting apparatus 19, beam expanding optics 20 and lithographic apparatuses LA1-LA8 may all be constructed and arranged such that they can be isolated from the external environment. A vacuum may be provided in at least part of the radiation source SO, beam expanding optics 20, beam splitting apparatus 19 and lithographic apparatuses LA1-LA8 so as to minimise the absorption of EUV radiation. Different parts of the lithographic system LS may be provided with vacuums at different pressures (i.e. held at different pressures which are below atmospheric pressure).

Referring to Figure 2, a lithographic apparatus LA1 comprises an illumination system IL, a support structure MT configured to support a patterning device MA (e.g. a mask), a projection system PS and a substrate table WT configured to support a substrate W. The illumination system IL is configured to condition the branch radiation beam $B_a$ that is received by that lithographic apparatus LA1 before it is incident upon the patterning device MA. The projection system PS is configured to project the radiation beam $B_a$' (now patterned by the mask MA) onto the substrate W. The substrate W may include previously formed patterns. Where this is the case, the lithographic apparatus aligns the patterned radiation beam $B_a$' with a pattern previously formed on the substrate W.

The branch radiation beam $B_a$ that is received by the lithographic apparatus LA1 passes into the illumination system IL from the beam splitting apparatus 19 though an opening 8 in an enclosing structure of the illumination system IL. Optionally, the branch radiation beam $B_a$ may be focused to form an intermediate focus at or near to the opening 8.

The illumination system IL may include a facetted field mirror device 10 and a facetted pupil mirror device 11. The faceted field mirror device 10 and faceted pupil mirror device 11 together provide the radiation beam $B_a$ with a desired cross-sectional shape and a desired angular distribution. The radiation beam $B_a$ passes from the illumination system IL and is incident upon the patterning device MA held by the support structure MT. The patterning device MA reflects and patterns the radiation beam to form a patterned beam $B_a$'. The illumination system IL may include other mirrors or devices in addition to or instead of the faceted field mirror device 10 and faceted pupil mirror device 11. The illumination system IL may for example include an array of independently moveable mirrors. The independently moveable mirrors may for example measure less than 1mm across. The independently moveable mirrors may for example be microelectromechanical systems (MEMS) devices.

Following reflection from the patterning device MA the patterned radiation beam $B_a$' enters the projection system PS. The projection system PS comprises a plurality of mirrors 13, 14 which are configured to project the radiation beam $B_a$' onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 2, the projection system may include any number of mirrors (e.g. six mirrors).

The radiation source SO configured to generate an EUV radiation beam B comprises a free electron laser. A free electron laser comprises a source, which is operable to produce a bunched relativistic electron beam, and a periodic magnetic field through which the bunches of relativistic electrons are directed. The periodic magnetic field is produced by an undulator and causes the electrons to follow an oscillating path about a central axis. As a result of the acceleration caused by the magnetic structure the electrons spontaneously radiate electromagnetic radiation generally in the direction of the central axis. The relativistic electrons interact with radiation within the undulator. Under certain conditions, this interaction causes the electrons to bunch together into microbunches, modulated at the wavelength of radiation within the undulator, and coherent emission of radiation along the central axis is stimulated.

The path followed by the electrons may be sinusoidal and planar, with the electrons periodically traversing the central axis, or may be helical, with the electrons rotating about the central axis. The type of oscillating path may affect the polarization of radiation emitted by the free electron laser. For example, a free electron laser which causes the electrons to propagate along a helical path may emit elliptically polarized radiation, which may be preferred for exposure of a substrate W by some lithographic apparatuses.

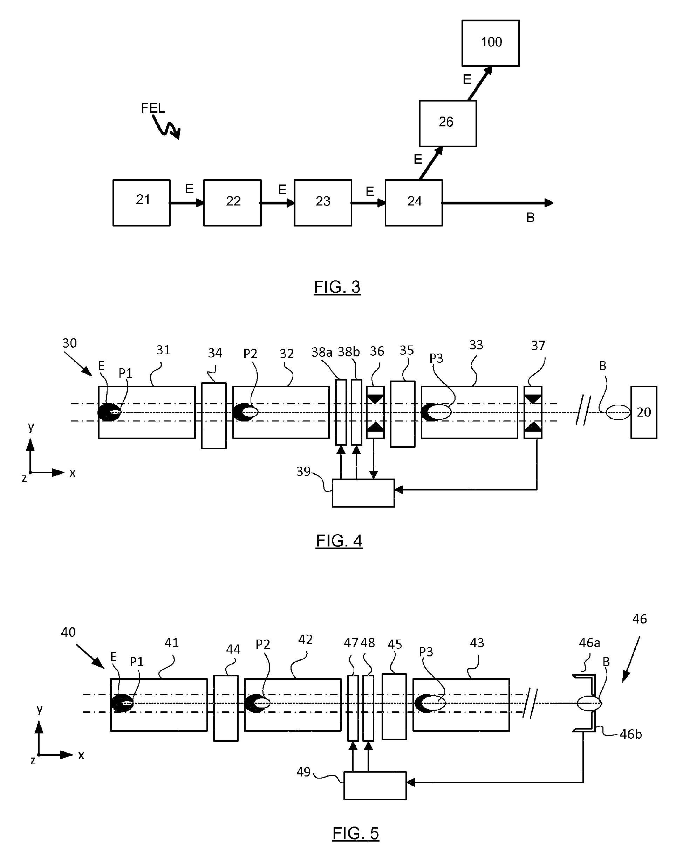

Figure 3 is a schematic depiction of a free electron laser FEL comprising an injector 21, a linear accelerator 22, an undulator 24 and a beam dump 100.

The injector 21 is arranged to produce a bunched electron beam E and comprises an electron source such as, for example, a thermionic cathode or photo-cathode and an accelerating electric field. The electron beam E is accelerated to relativistic speeds by the linear accelerator 22. In an example, the linear accelerator 22 may comprise a plurality of radio frequency cavities, which are axially spaced along a common axis, and one or more radio frequency power sources, which are operable to control the electromagnetic fields along the common axis as bunches of electrons pass between them so as to accelerate each bunch of electrons. The cavities may be superconducting radio frequency cavities. Advantageously, this allows: relatively large electromagnetic fields to be applied at high duty cycles; larger beam apertures, resulting in fewer losses due to wakefields; and for the fraction of radio frequency energy that is transmitted to the beam (as opposed to dissipated through the cavity walls) to be increased. Alternatively, the cavities may be conventionally conducting (i.e. not superconducting), and may be formed from, for example, copper. Other types of linear accelerators may also be used. For example, the linear accelerator 22 may comprise a laser accelerator, wherein the electron beam E passes through a focused laser beam and the electric field of the laser beam causes the electrons to accelerate.

The injector 21 and linear accelerator 22 together form an electron source that is operable to produce relativistic electrons.

Optionally, the electron beam E may pass through a bunch compressor 23. The bunch compressor 23 may be disposed downstream or upstream of the linear accelerator 22. The bunch compressor 23 is configured to bunch electrons in the electron beam E and spatially compress existing bunches of electrons in the electron beam E. One type of bunch compressor 23 comprises a radiation field directed transverse to the electron beam E. An electron in the electron beam E interacts with the radiation and bunches with other electrons nearby. Another type of bunch compressor 23 comprises a magnetic chicane, wherein the length of a path followed by an electron as it passes through the chicane is dependent upon its energy. This type of bunch compressor may be used to compress a bunch of electrons which have been accelerated in a linear accelerator 22 using a plurality of radio frequency cavities.

The electron beam E then passes through the undulator 24. Generally, the undulator 24 comprises a plurality of magnets, which are operable to produce a periodic magnetic field and arranged so as to guide the relativistic electrons produced by the injector 21 and linear accelerator 22 along a periodic path. As a result, the electrons radiate electromagnetic radiation generally in the direction of a central axis of the undulator 24. The undulator 24 comprises a plurality of modules, each section comprising a periodic magnet structure. The electromagnetic radiation may form bunches (referred to as photon bunches herein) at the beginning of each undulator module. The undulator 24 further comprises a mechanism for refocusing the electron beam E such as, for example, a quadrupole magnet in between one or more pairs of adjacent modules. The mechanism for refocusing the electron beam E may reduce the size of the electron bunches, which may improve the coupling between the electrons and the radiation within the undulator 24, increasing the stimulation of emission of radiation.

The free electron laser FEL may operate in self-amplified stimulated emission (SASE) mode. Alternatively, the free electron laser FEL may comprise a seed radiation source, which may be amplified by stimulated emission within the undulator 24. A beam of radiation B propagates from the undulator 24. The radiation beam B comprises EUV radiation.

As electrons move through the undulator 24, they interact with the electric field of the radiation, exchanging energy with the radiation. In general the amount of energy exchanged between the electrons and the radiation will oscillate rapidly unless conditions are close to a resonance condition, given by:

$$\lambda_{em} = \frac{\lambda_u}{2\gamma^2}\left(1 + \frac{K^2}{A}\right), \qquad\qquad (1)$$

where $\lambda_{em}$ is the wavelength of the radiation, $\lambda_u$ is the undulator period, $\gamma$ is the Lorentz factor of the electrons and K is the undulator parameter. A is dependent upon the geometry of the undulator 24: for a helical undulator A=1, whereas for a planar undulator A=2. In practice, each bunch of electrons will have a spread of energies although this spread may be minimised as far as possible (by producing an electron beam $EB_1$ with low emittance). The undulator parameter K is typically approximately 1 and is given by:

$$K = \frac{q\lambda_u B_0}{2\pi mc}, \qquad\qquad (2)$$

where *q* and *m* are, respectively, the electric charge and mass of the electrons, $B_0$ is the amplitude of the periodic magnetic field, and *c* is the speed of light.

The resonant wavelength $\lambda_{em}$ is equal to the first harmonic wavelength spontaneously radiated by electrons moving through the undulator 24. The free electron laser FEL may operate in self-amplified stimulated emission (SASE) mode. Operation in SASE mode may require a low energy spread of the electron bunches in the electron beam $EB_1$ before it enters the undulator 24. Alternatively, the free electron laser FEL may comprise a seed radiation source, which may be amplified by stimulated emission within the undulator 24.

Electrons moving through the undulator 24 may cause the amplitude of radiation to increase, i.e. the free electron laser FEL may have a non-zero gain. Maximum gain may be achieved when the resonance condition is met or when conditions are close to but slightly off resonance.

An electron which meets the resonance condition as it enters the undulator 24 will lose (or gain) energy as it emits (or absorbs) radiation, so that the resonance condition is no longer satisfied. Therefore, in some embodiments the undulator 24 may be tapered. That is, the amplitude of the periodic magnetic field and/or the undulator period $\lambda_u$ may vary along the length of the undulator 24 in order to keep bunches of electrons at or close to resonance as they are guided though the undulator 24. Note that the interaction between the electrons and radiation within the undulator 24 produces a spread of energies within the electron bunches. The tapering of the undulator 24 may be arranged to maximise the number of electrons at or close to resonance. For example, the electron bunches may have an energy distribution which peaks at a peak energy and the tapering maybe arranged to keep electrons with this peak energy at or close to resonance as they are guided though the undulator 24. Advantageously, tapering of the undulator has the capacity to significantly increase conversion efficiency. The use of a tapered undulator may increase the conversion efficiency (i.e. the portion of the energy of the electron beam E which is converted to radiation in the radiation beam B) by more than a factor of 2. The tapering of the undulator may be achieved by reducing the undulator parameter *K* along its length. This may be achieved by matching the undulator period $\lambda_u$ and/or the magnetic field strength $B_0$ along the axis of the undulator to the electron bunch energy to ensure that they are at or close to the resonance condition. Meeting the resonance condition in this manner increases the bandwidth of the emitted radiation.

After leaving the undulator 24, the electromagnetic radiation (photon bunch) is emitted as the radiation beam B. The radiation beam B supplies EUV radiation to the lithographic apparatuses LA1 to LA8. The radiation beam B may optionally be directed to dedicated optical components which may be provided to direct the radiation beam B from the free electron laser FEL to the lithographic apparatuses LA1 to LA8. Since EUV radiation is generally well absorbed by all matter, reflective optical components are used (rather than transmissive components) so as to minimise losses. The dedicated optical components may adapt the properties of the radiation beam produced by the free electron laser FEL so that it is suitable for acceptance by the illumination systems IL of the lithographic apparatuses LA1 to LA8. The dedicated optical components may include the expander optics 20 and the beam splitter 19 depicted in Figure 1.

After leaving the undulator 24, the electron beam E is absorbed by a dump 100, which may, for example, include a large amount of water or a material with a high threshold for radioactive isotope generation by high energy electron impact, for example Al with threshold of approximately 15 MeV. Before passing to the dump 100, it may be desirable to extract energy from the electron beam E to reduce its radioactivity and/or to recover at least part of the energy.

In order to reduce the energy of the electrons before they are absorbed by the beam dump 100, an electron decelerator 26 is disposed between the undulator 24 and the beam dump 100. The electron decelerator 26 reduces the amount of energy the electrons have when they are absorbed by the beam dump 100 and will therefore reduce the levels of induced radiation and secondary particles produced in the beam dump 100. This removes, or at least reduces, the need to remove and dispose of radioactive waste from the beam dump 100. This is advantageous since the removal of radioactive waste requires the free electron laser FEL to be shut down periodically and the disposal of radioactive waste can be costly and can have serious environmental implications.

The electron decelerator 26 may be operable to reduce the energy of the electrons to below a threshold energy. Electrons below this threshold energy may not induce any significant level of radioactivity in the beam dump 100. During operation of the free electron laser FEL, gamma radiation will be present but advantageously when the electron beam E is switched off, the beam dump 100 will be safe to handle.

While not discernible from the schematic illustration of Figure 1, the FEL of the source SO is placed at a relatively large distance from the beam expander 20 and the beam splitting apparatus 19 due to thermal requirements. For example, the FEL may be arranged to produce a radiation beam with an output power of the order of tens of kilowatts. For such embodiments, a distance between exit of the undulator 24 and the beam expander 20 may be of the order of tens or hundreds of meters. The distance between the FEL and the beam expander 20 and the beam splitting apparatus 19 is such that the lithographic system LS has a high sensitivity to changes in the pointing direction and divergence of the radiation beam B exiting the undulator 24. Instability in the pointing and divergence of the radiation beam B may be caused by a number of factors such as mechanical vibrations during use. Displacement of the radiation beam B with respect to the beam expander 20 and the beam splitting apparatus 19 can lead to undesirable changes in the amount of EUV radiation that is supplied to each of the lithographic apparatus LA1-LA8.

Figures 4 to 7 below illustrate different arrangements of the undulator 24. In each case it is to be understood that the radiation beam B emitted from the described undulator arrangement is as described above with reference to Figure 3.

An undulator 30 which may be used to implement the undulator 24 in one embodiment is schematically illustrated in Figure 4. The undulator 30 comprises a plurality of undulator modules 31, 32, 33 through which the bunched electron beam E is transmitted. An envelope of the electron beam E as it passes through the undulator 30 is depicted by dot-dash line. While only three modules 31, 32, 33 are shown in Figure 4, it is to be understood that more or fewer modules may be provided. The undulator modules 31, 32, 33 may be implemented in any appropriate way, but as described above generally comprise a plurality of magnets which produce a periodic magnetic field. For each undulator module 31, 32, 33, a portion of a volume around a central axis of the undulator module may be considered to be a "good field region" (not shown). The good field region is a volume around the central axis in which the magnitude and direction of the magnetic field at a particular point is substantially equal to values at the closest point on axis of undulator. An electron bunch propagating within the good field region will satisfy the resonant condition of equation (1) and therefore will amplify radiation. Further, an electron beam E propagating within the good field region should not experience significant unexpected disruption due to uncompensated magnetic fields.

Photon bunches P1, P2, P3 are shown generally overlapping with the electron bunch E at the beginning of each undulator module 31, 32, 33 respectively. It can be seen that the photon bunch increases along the longitudinal axis of the undulator 30 from left to right in the Figure. Due to a phenomenon commonly known as optical guiding, the photon bunches P1, P2, P3 generally follow the electron beam E within each undulator module 31, 32, 33. Optical guiding is a consequence of two effects. The first effect is a result of light refraction within the electron beam E. Because the real part of the refraction index of the electron beam is maximal close to or at the electron beam center, the electron beam guides light in a similar manner to an optical fiber. The second effect is light amplification, because the gain of the FEL is highest where the current density is highest (that is close to or at the center of the electron beam E).

Between the undulator modules (known as drift space), the photons and electrons are decoupled (i.e. they do not interact with each other).

The bunched electron beam E has a finite emittance and will therefore increase in diameter unless refocused. The undulator 30 therefore further comprises two refocusing elements 34, 35 each positioned between a different pair of adjacent modules (the modules 31,32 and 32, 33 respectively). Where additional modules are provided, a refocusing element may be provided between each module. The refocusing elements 34, 35 may comprise, for example, quadrupole magnets.

The undulator 30 further comprises two beam position monitors (BPMs) 36, 37 adapted to measure a deviation from an ideal position of the electron beam E within the undulator 30 at two different axial locations. Although the envelope shown in Figure 4 follows a uniform path, in practice the electron beam E may deviate from this path such that the envelope is distorted. This distortion may be detected by the BPMs 36, 37. The BPMs 36, 37 may implemented in any of a number of ways as will be readily appreciated the skilled person.

Deviation of the trajectory of the electron beam E within an undulator will cause similar deviation of the trajectory of the radiation beam B. As a result of this deviation, the radiation beam B may not reach, or may not fall upon an optimal or acceptable portion of downstream optics such as optics within the expander 20. It has been realised, however, that distortion of the trajectory of the radiation beam B may be addressed within the undulator itself, and may be addressed in the final modules of the undulator.

The undulator 30 further comprises two electron beam steering units 38a, 38b positioned between the module 32 and the BPM 36. The electron beam steering units 38a, 38b are arranged to steer the electron beam E, in both horizontal (z) and vertical (y) directions. The BPMs 36, 37 are connected to a control unit 39 arranged to receive signals indicative of a position of the electron beam E from each of the BPMs 36, 37. The control unit 39 is arranged to determine an amount by which the trajectory of the electron beam E deviates from a desired trajectory and to control the beam steering units 38a, 38b to steer the electron beam E such that it substantially follows the desired trajectory.

Due to the distance between the exit of the undulator 24 and beam expander 20, the lithographic system LS is more sensitive to changes in the tilt of the radiation beam B (i.e. the angle between the propagation direction of the radiation beam B and the longitudinal axis of the undulator 24) than it is to translation of the radiation beam B (i.e. an offset between the propagation direction of the radiation beam B and the longitudinal axis of the undulator 24). The arrangement 30 shown in Figure 4 provides a system which is able to correct a tilt of the radiation beam B at the exit of the undulator 24, where correction of the tilt is most effective.

In this way, the undulator 30 provides an arrangement which is able to align the electron beam E, and therefore the radiation beam B, with an ideal axis of propagation. Alternatively, or additionally, because the lithographic system LS is more sensitive to the tilt of the radiation beam B than to translation of the radiation beam B, the undulator 30 may be used to produce an electron beam E that is parallel to a desired axis of propagation of the radiation beam B where an amount of translation of the radiation beam B away from an ideal axis of propagation is within a tolerance. In this way, the radiation beam B may still be properly processed by downstream optical elements such as the beam expander 20 and the beam splitter 19. In an embodiment, downstream optical elements may themselves be translated in response to detected translations of the radiation beam B.

It will be appreciated that the positions and numbers of the components depicted in the undulator 30 are merely exemplary. For example, more than two BPMs may be provided, and more or fewer beam steering units may be provided. In alternative embodiments, the steering units 38a, 38b and the BPMs 36, 37 may be positioned differently within the undulator 30. It has been determined to be advantageous, however, that the steering units are placed relatively close to the output of the undulator 30, to reduce the effect of additional causes of displacement or instability on the electron beam E and, consequently, the radiation beam B.

Figure 5 illustrates an alternative undulator 40 that may be used to provide the undulator 24 of Figure 3. The undulator 40 comprises a plurality of modules 41, 42, 43. While only three modules are shown in Figure 5, it is to be understood that more or fewer modules may be provided. The undulator 40 further comprises two refocusing elements 44, 45 positioned between the modules 41, 42 and 42, 43 respectively, which may be implemented similarly to the refocusing modules 32, 33 of Figure 4. The undulator 40 further comprises an EUV intensity distribution sensor 46 arranged to measure an intensity distribution within the radiation beam B. The intensity distribution sensor 46 may be implemented in any suitable way as will be readily apparent to the skilled person.

The intensity distribution sensor 46 is depicted as comprising two parts, 46a, 46b vertically separated (in the y- direction). In this way, for example, if the part 46a detects an increase in EUV power and the part 46b simultaneously detects a decrease in EUV power, it may be determined that the beam has shifted in the y- direction towards the sensor 46a. It will be appreciated, that the intensity distribution sensor 46 may comprise other parts. For example, the intensity distribution sensor 46 may also comprise parts separated in the z-direction, and may comprise parts separated in the x- direction. Further, the intensity distribution sensor may comprise parts separated in more than one direction. The undulator 40 further comprises two electron beam steering units 47, 48 positioned between the module 42 and the refocusing element 45. The electron beam steering units 47, 48 are arranged to steer the electron beam E within the undulator in both horizontal (z-) and vertical (y-) directions.

The intensity distribution sensor 46 is connected to a control unit 49 and is arranged to transmit signals indicating an intensity distribution within the radiation beam B to the control unit 49. The control unit 49 is arranged to: process the received indications from the intensity distribution sensor 46; and to compare the intensity distribution within the radiation beam B with a desired intensity distribution. If the intensity distribution indicated by the intensity distribution sensor 46 deviates from the desired intensity distribution, the control unit 49 transmits control signals to the beam steering units 47, 48 to steer the electron beam E, and therefore the radiation beam B so that the intensity distribution of the radiation beam B is closer to the desired intensity distribution.

In this way, the centre of the radiation beam B may be directed toward a centre position of a beam acceptance centre (or a sweet spot) of the optics within the beam expander 20.

While shown as part of the undulator 40, in an embodiment, one or more intensity distribution sensors 46 may be placed at the entrance to, and/or exit of, the beam expander optics 20. The intensity distribution sensor 46 may however be placed at any position along the path of the radiation beam B.

As described above, the path followed by the electron beam E through the undulator 24 may be sinusoidal and planar, with the electrons periodically traversing the central axis, or may be helical, with the electrons rotating about the central axis. Generally, for helical paths, a tilt of the electron beam E within the undulator 24 should not exceed $1/10\rho$, where $p$ is the Pierce parameter. In an embodiment, the Pierce parameter may be of the order of 0.1% indicating that an amount of steering performed by the steering units 38a, 38b or 47, 48 is likely to be less than 100 $\mu$rad.

The bending of a relativistic electron beam is described by the formula (3):

$$\frac{1}{r} = \frac{ecB}{w} \qquad\qquad (3)$$

where $r$ is the bending radius, e is the charge of an electron, $B$ is the magnetic field, and w is the energy of the beam. From this it can be shown that the product of the magnetic field strength $B$ in Tesla and the bending radius $r$ in meters is approximately given by the energy w of the electron beam E in MeV divided by 300. (i.e. B*$\rho$ (T*m) ≈ E (MeV)/300). For embodiments wherein the steering units comprise a steering magnet of having a length of approximately 0.1 m, a bend angle of 10 $\mu$rad may be achieved with a magnetic field of approximately $2*10^{-4}$ T while a bend angle of approximately 100 $\mu$rad can be achieved with a magnetic field of 2 mT. As such, steering the electron beam E through bends of less than 100 $\mu$rad can be achieved with relatively small magnetic fields which may be quickly established within the steering units 38a, 38b and 47, 48.

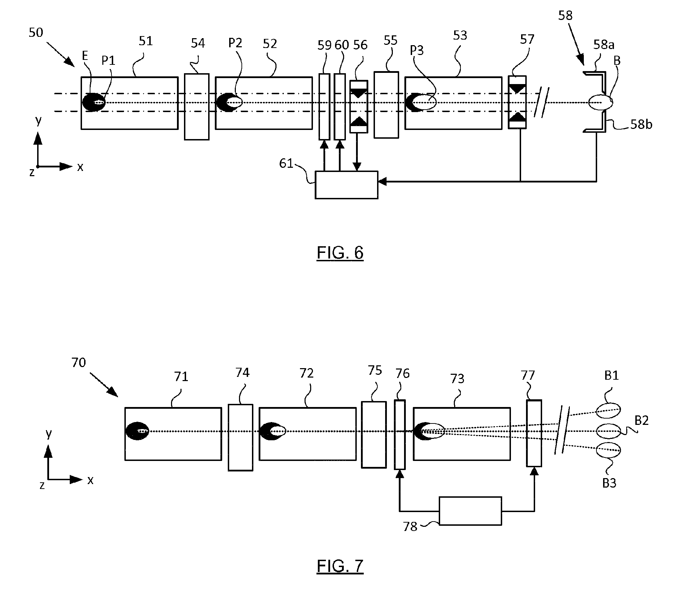

It will be appreciated that the features of the arrangements depicted in the arrangements of Figures 4 and 5 may be combined. Figure 6 illustrates an undulator 50 which may be used to provide the undulator 24 and which comprises modules 51, 52, 53 and refocusing elements 54, 55. The undulator 50 further comprises BPMs 56, 57 which are equivalent to the BPMs 36, 37 of the arrangement of Figure 4. The undulator 50 further comprises an intensity distribution sensor 58 (having parts 58a, 58b) which is equivalent to the intensity distribution sensor 46 in the arrangement of Figure 5. The undulator 50 further comprises beam steering units 59, 60 arranged to receive instructions from a control unit 61. In the undulator 50, the control unit 61 is arranged to receive signals indicative of a trajectory of the electron beam E from the BPMs 56, 57 and to receive signals indicative of a distribution of EUV radiation within the radiation beam B from the intensity distribution sensor 58. In this way, the control unit 61 may steer the electron beam E (using the steering units 59, 60) in dependence upon deviations within both the trajectory of the electron beam E and/or an intensity distribution of the radiation beam B.

Figure 7 illustrates an undulator 70 that may be used to implement the undulator 24 in an alternative embodiment. For clarity, the electron beam envelope is not depicted in Figure 7. The undulator 70 comprises three modules 71, 72, 73 and two refocusing elements 74, 75. The module 73 is a planar module. That is, the path followed by the electrons of the electron beam E within the module 73 is sinusoidal and planar, rather than helical. The modules 71, 72 may be helical or planar. The undulator 70 further comprises a first steering unit 76 placed before the module 73 and a second steering unit 77 placed after the module 73. A control unit 78 is in communication with both the first and second steering units 76, 77.

The control unit 77 is arranged to provide instructions to the first steering unit 76 to actively, and periodically, alter the trajectory of the electron beam E and thereby redistribute the radiation beam B in the far-field. In particular, the steering unit 76 may be controlled to periodically deflect the electron beam E through a deflection angle. The undulator 70 may therefore sequentially direct the radiation beam B along different and spatially separated trajectories so as to provide separate EUV radiation beams B1, B2, B3 to different ones of the lithographic apparatus LA1 - LA8. It will be appreciated that while only three radiation beams B1, B2, B3 are shown in Figure 7, more or fewer radiation beams may be provided. For example, a respective radiation beam may be provided for each lithographic apparatus LA1 to LA8.

In such embodiments, the beam splitting apparatus 19 may not be required, or may be simplified. For example, by deflecting the electron beam E so as to provide a respective separate radiation beams for each lithographic apparatus, it is not required to split a single radiation beam for provision to those multiple lithographic apparatus. Alternatively, where more than one radiation beam is provided, but a separate radiation beam is not provided each lithographic apparatus, each radiation beam need be split into fewer beams by a beam splitting apparatus for provision to each lithographic apparatus.

Where multiple radiation beams are provided by the undulator 70, each radiation beam may be provided with respective beam expanding optic 20.

Alternatively or additionally, the control unit 78 may cause the steering unit 76 to periodically sweep the electron beam E through a predetermined angle with substantially constant angular speed. In example embodiments, the electron beam E may be swept through angles of 10 $\mu$rad, 100 $\mu$rad or 1000 $\mu$rad, although it will be appreciated that the electron beam E may be swept through other angles.

By sweeping the electron beam E, the intensity profile of the resulting radiation beam B, when averaged over a number of emitted pulses, may comprise a substantially flat-top intensity distribution (also known as a top-hat distribution) in the far-field with increased divergence compared to a non-swept beam. A radiation beam B produced by sweeping the electron beam E through an angle may therefore not need to be conditioned by the expanding optics 20 to provide a flat-top distribution. Further, while further expansion of the radiation beam B may be performed by the expanding optics 20, any required expansion will be reduced.

The second steering unit 77 is arranged after the module 73 to redirect the electron beam E altered by the first steering unit 76 towards the steering unit 26 and the dump 100. Both the steering unit 76 and the steering unit 77 steer the electron beam E in the plane perpendicular to the magnetic field lines in the module 73.

While the steering unit 76 is placed before the final module 73 of the undulator 70, in other embodiments, the steering unit 76 may be placed before a module that is not the last module of the undulator 70 (for example the module 72). In preferred embodiments, however, the steering unit 76 is placed within a final portion of the undulator. For example, the steering unit may be placed before module that is closer to an exit of the undulator 70 than it is to an entrance of the undulator 70.

It will also be appreciated that the embodiment of Figure 6 may be combined with the embodiments of Figures 3 to 5. For example, BPMs may be provided in the arrangement of Figure 6 to ensure that the electron beam is swept through the correct angular range. Similarly, one or more intensity distribution modules may be provided to monitor an intensity distribution of the single (averaged over time) or multiple radiation beams provided by an undulator arranged similarly to the undulator 70.

It is to be understood that while eight lithographic apparatus LA1-LA8 are described above, more of fewer lithographic apparatus may be provided in a lithographic system. Further, one or more of the lithographic apparatus LA1-LA8 may comprise a mask inspection apparatus MIA. In some embodiments, the lithographic system may comprise two mask inspection apparatuses to allow for some redundancy. This may allow one mask inspection apparatus to be used when the other mask inspection apparatus is being repaired or undergoing maintenance. Thus, one mask inspection apparatus is always available for use. A mask inspection apparatus may use a lower power radiation beam than a lithographic apparatus.

The term "EUV radiation" may be considered to encompass electromagnetic radiation having a wavelength within the range of 5-20 nm, for example within the range of 13-14 nm. EUV radiation may have a wavelength of less than 10 nm, for example within the range of 5-10 nm such as 6.7 nm or 6.8 nm.

The lithographic apparatuses LA1 to LA8 may be used in the manufacture of ICs. Alternatively, the lithographic apparatuses LA1 to LA8 described herein may have other applications. Possible other applications include the manufacture of integrated optical systems, guidance and detection patterns for magnetic domain memories, flat-panel displays, liquid-crystal displays (LCDs), thin-film magnetic heads, etc.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Claims

1. An undulator for a free electron laser, comprising:

at least one undulator module operable to produce a periodic magnetic field and arranged so as to guide an electron beam along a periodic path such that electrons within the electron beam interact with radiation in the undulator to stimulate emission of coherent radiation to provide a radiation beam;
a steering unit arranged to alter a trajectory of the electron beam within the at least one undulator module; and
a control unit arranged to control to the steering unit.

2. The undulator of claim 1, wherein the steering unit is positioned within the undulator at a location that is nearer to an exit of the undulator than an entrance of the undulator in relation to the direction of propagation of the electron beam.

3. The undulator of claim 1, wherein the steering unit is positioned between a final and a penultimate module of the undulator with respect to direction of propagation of the electron beam.

4. The undulator of claim 1, 2 or 3, further comprising a sensor arrangement for providing a signal indicative of a trajectory of the electron beam to the control unit.

5. The undulator of any preceding claim, wherein the sensor arrangement comprises a plurality of undulator modules and a first sensor positioned after a first one of the plurality of undulator modules and a second sensor positioned after a second one of the plurality of undulator modules.

6. The undulator of claim 5, wherein the first sensor is positioned after a penultimate module and the second sensor is positioned after a final module.

7. The undulator of claim 4, 5 or 6, wherein the control unit is arranged to determine a deviation of the trajectory of the electron beam from an ideal trajectory.

8. The undulator of claim 7, wherein the control unit is arranged to control the steering unit to reduce a difference between the trajectory of the electron beam and the ideal trajectory, or to substantially align the electron beam with a trajectory parallel to the ideal trajectory.

9. The undulator of any preceding claim, wherein the control unit is arranged to receive an indication of an intensity distribution within the radiation beam at a predetermined location.

10. The undulator of claim 9, wherein the undulator is arranged to determine a difference between the intensity distribution within the radiation beam at the predetermined location and an ideal intensity distribution within the radiation beam at the predetermined location; and
to control the steering unit to reduce the difference between the intensity distribution within the radiation beam at the predetermined location and an ideal intensity distribution within the radiation beam at the predetermined location.

11. The undulator of any preceding claim, wherein the control unit is arranged to control the steering unit to periodically vary the trajectory of the electron beam by a predetermined amount.

12. The undulator of claim 11, wherein the control unit is arranged to control steering unit to sequentially direct the electron beam at a plurality of discreet angles with respect to a longitudinal axis of the undulator.

13. The undulator of claim 12, wherein the plurality of discreet angles is selected so as to provide a plurality of spatially separate radiation beams.

14. The undulator of claim 11, wherein the control unit is arranged to control the steering unit to sweep the electron beam through a predetermined angular range with respect to a longitudinal axis of the undulator.

15. The undulator of claim 12 or 14, wherein the control unit is arranged to control the steering unit so as to provide a plurality of spatially overlapping radiation beams.

16. The undulator of claim 14 or 15, wherein the control unit is arranged to control the steering unit to sweep the electron beam through the predetermined angular range with a substantially constant angular speed.

17. The undulator of any of claims 11 to 16, wherein the control unit is arranged to control the steering unit to vary the trajectory up to an angle of 1000 $\mu$rad in a direction perpendicular to a longitudinal axis of the undulator.

18. The undulator of any preceding claim, comprising a plurality of steering units controlled by the control unit to alter a direction of the electron beam.

19. A free electron laser arranged to produce at least one radiation beam comprising the undulator of any preceding claim.

20. A lithographic system comprising:

a free electron laser arranged to produce at least one radiation beam according to claim 19; and
at least one lithographic apparatus, each of the at least one lithographic apparatus being arranged to receive at least one of the at least one radiation beams.

21. The lithographic system of claim 20, further comprising optics arranged to alter the size and/or shape of the cross section of the at least one radiation beams received from the free electron laser.

22. The lithographic system of claim 20 or 21, further comprising an intensity distribution sensor arranged to provide signals indicative of an intensity distribution within the at least one radiation beam to the control unit of the undulator.

23. The lithographic system of any one of claims 18 to 22, wherein the at least one lithographic apparatus comprises one or more mask inspection apparatus.

24. The lithographic system of any one of claims 18 to 23, wherein the at least one radiation beam comprises EUV radiation

**25.** A computer implemented method for varying a direction of an electron beam within an undulator operable to produce a periodic magnetic field and arranged so as to guide the electron beam along a periodic path such that electrons within the electron beam interact with radiation in the undulator to stimulate emission of coherent radiation to provide a radiation beam, the method comprising:

receiving a signal indicative of a trajectory of the electron beam and/or receiving a signal indicative of an intensity distribution within the radiation beam at a predetermined location;

determining a deviation of the trajectory of the electron beam from an ideal trajectory and/or determining a difference between the intensity distribution within the radiation beam at the predetermined location and an ideal intensity distribution within the radiation beam at the predetermined location; and

controlling a steering unit within the undulator to steer the electron beam within a module of the undulator so as to reduce the determined deviation and/or so as to reduce the determined difference.

FIG. 1

FIG. 2

FIG. 3

FIG. 4

FIG. 5

FIG. 6

FIG. 7

Europäisches
Patentamt

European
Patent Office

Office européen
des brevets

# EUROPEAN SEARCH REPORT

Application Number

EP 14 15 1497

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DI MITRI S ET AL: "FERMI@Elettra, a seeded free electron laser source for a broad scientific user program", ADVANCES IN X-RAY FREE-ELECTRON LASERS: RADIATION SCHEMES, X-RAY OPTICS, AND INSTRUMENTATION, SPIE, 1000 20TH ST. BELLINGHAM WA 98225-6705 USA, vol. 8078, no. 1, 5 May 2011 (2011-05-05), pages 1-13, XP060013781, DOI: 10.1117/12.886491 [retrieved on 1901-01-01] | 1-10,18, 19,25 | INV. G03F7/20 H01S3/09 H05H7/04 |
| Y | * paragraph [0001] * | 20-24 | |
| A | * paragraph [02.2]; figure 3.2 * | 11-17 | |
| | ----- | | |
| X | YU L-H ET AL: "The DUV-FEL development program", PROCEEDINGS OF THE 2001 PARTICLE ACCELERATOR CONFERENCE : CHICAGO, ILLINOIS, U.S.A., JUNE 18 - 22, 2001, IEEE OPERATIONS CENTER, PISCATAWAY, NJ, vol. 4, 18 June 2001 (2001-06-18), pages 2830-2832, XP010581749, DOI: 10.1109/PAC.2001.987925 ISBN: 978-0-7803-7191-0 | 1-10,18, 19,25 | |
| | | | TECHNICAL FIELDS SEARCHED (IPC) |
| Y | * paragraph [0002] * | 20-24 | G03F H01S H05H |
| | ----- | | |
| Y | US 2007/152171 A1 (GOLDSTEIN MICHAEL [US] ET AL) 5 July 2007 (2007-07-05) * paragraph [0019] - paragraph [0031]; figures 1,4 * | 20,21,24 | |
| | ----- | | |
| | -/-- | | |

The present search report has been drawn up for all claims

| Place of search | Date of completion of the search | Examiner |
|---|---|---|
| Munich | 27 November 2014 | van Toledo, Wiebo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

# EP 2 896 995 A1

**Europäisches Patentamt**

**European Patent Office**

**Office européen des brevets**

## EUROPEAN SEARCH REPORT

Application Number

EP 14 15 1497

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2002/018189 A1 (MULKENS JOHANNES CATHARINUS HU [NL] ET AL) 14 February 2002 (2002-02-14) * paragraph [0034] * * paragraph [0050] - paragraph [0052]; figure 1 * * paragraph [0061] - paragraph [0063]; figure 3 * | 22 | |
| Y | GIOVANNI CIRMI ET AL: "Paper;Cut-off scaling of high-harmonic generation driven by a femtosecond visible optical parametric amplifier;Cut-off scaling of high-harmonic generation driven by a femtosecond visible optical parametric amplifier", JOURNAL OF PHYSICS B, ATOMIC MOLECULAR AND OPTICAL PHYSICS, INSTITUTE OF PHYSICS PUBLISHING, BRISTOL, GB, vol. 45, no. 20, 12 September 2012 (2012-09-12), page 205601, XP020229911, ISSN: 0953-4075, DOI: 10.1088/0953-4075/45/20/205601 * page 8, paragraph 1 * | 23 | |

TECHNICAL FIELDS SEARCHED (IPC)

The present search report has been drawn up for all claims

| Place of search | Date of completion of the search | Examiner |
|---|---|---|
| Munich | 27 November 2014 | van Toledo, Wiebo |

EPO FORM 1503 03.82 (P04C01)

17

**ANNEX TO THE EUROPEAN SEARCH REPORT
ON EUROPEAN PATENT APPLICATION NO.**

EP 14 15 1497

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2014

| Patent document cited in search report | Publication date | Patent family member(s) | | Publication date |
|---|---|---|---|---|
| US 2007152171 A1 | 05-07-2007 | NONE | | |
| US 2002018189 A1 | 14-02-2002 | JP | 2002015993 A | 18-01-2002 |
| | | TW | I226972 B | 21-01-2005 |
| | | US | 2002018189 A1 | 14-02-2002 |

For more details about this annex : see Official Journal of the European Patent Office, No. 12/82

EPO FORM P0459